# EUROPEAN PATENT SPECIFICATION

(11) **EP 0 950 082 B1**
(45) Date of publication and mention of the grant of the patent: **23.04.2003**
(21) Application number: 97952684.5
(22) Date of filing: 29.12.1997
(51) Int. Cl.: C09J 5/02, C08J 3/24, H01L 21/58

(54) **REDUCING VOID FORMATION IN CURABLE ADHESIVE FORMULATIONS**
VERMINDERUNG DER BILDUNG VON HOHLRÄUMEN IN HÄRTBAREN KLEBSTOFFZUSAMMENSETZUNGEN
REDUCTION DE LA FORMATION DE VIDES DANS DES FORMULES D'ADHESIFS DURCISSABLES

(30) Priority: 06.01.1997 US 781995
(43) Date of publication of application: 20.10.1999
(73) Proprietor: QUANTUM MATERIALS, INC., San Diego, CA 92126 (US)
(72) Inventor: FORRAY, Deborah, Derfelt, San Diego, CA 92117 (US)
(74) Representative: Fiener, Josef
(86) International application number: US9724188
(87) International publication number: WO98030647

(56) References cited:
- WO-A-95/07309
- GB-A- 2 179 001
- US-A- 4 312 692
- US-A- 4 714 726
- US-A- 4 916 805
- US-A- 5 488 082
- US-A- 5 644 837

## Description

The present invention relates to compositions useful for bonding electronic devices to supports therefor, as well as methods for achieving the desired bonding and substantially void-free articles produced thereby.

### BACKGROUND OF THE INVENTION

The micro-electronics industry uses various substrates for the attachment of microelectronic devices thereto. Most of these devices are attached to suitable substrates using some kind of adhesive material. Unfortunately, many of the substrates and/or devices commonly used in the micro-electronics industry tend to absorb moisture. When subjected to the elevated temperatures required to cure such adhesive materials, various levels of void formation can occur as a result of the release of absorbed moisture and/or other volatile materials which may be released by the device and/or substrate at elevated temperatures.

The formation of voids can lead to a severe reduction in the reliability of the resulting article, due to disruption of the adhesive interface between the device and substrate. It would be desirable, therefor, to develop compositions and methods for the use thereof which allow the assembly and adhesion of device to substrate without the creation of substantial level of voids in the finished article.

### BRIEF DESCRIPTION OF THE INVENTION

In accordance with the present invention, adhesive formulations have been developed which enable curing of adhesively bonded assemblies (i.e., assemblies which comprise devices which have been adhesively bonded to substrates) with dramatically reduced occurrence of void formation upon curing. In many instances, void formation can be eliminated employing invention compositions.

In accordance with another aspect of the present invention, methods employing the above-described adhesive formulations are also provided, as are substantially void-free articles produced thereby.

### DETAILED DESCRIPTION OF THE INVENTION

In accordance with the present invention, there are provided methods to reduce void formation upon curing of an adhesive formulation employed to bond a device to a substrate, wherein said device and/or said substrate are prone to release volatiles at elevated temperatures. Invention methods comprise using as a curing catalyst for such adhesive formulations a catalyst which initiates curing of the formulation at a temperature of less than about 100°C.

Adhesive formulations contemplated for use in the practice of the present invention include cyanate ester-based formulations, maleimide-based formulations, epoxy-based formulations, (meth)acrylate-based formulations, vinyl ether-based formulations, vinyl ester-based formulations, allyl ester-based formulations, diallyl amide-based formulations, propargyl ether-based formulations, formulations based on a polysiloxane backbone terminated with one or more of the above-described functional groups, formulations based on a preimidized polyimide backbone terminated with one or more of the above-described functional groups, and the like, as well as mixtures of any two or more thereof.

A wide variety of cyanate ester-based formulations are suitable for use in the practice of the present invention. Numerous examples of such formulations have been described in the art. See, for example, U.S. Patent No. 5,447,988, U.S. Patent No. 5,358,992, U.S. Patent No. 5,489,641, each of which are hereby incorporated by reference herein in their entirety.

A wide variety of maleimide-based formulations are suitable for use in the practice of the present invention. Numerous examples of such formulations have been described in the art. See, for example, United States Serial No. 08/300,721, filed September 2, 1994, United States Serial No. 08/460,495, filed June 2, 1995, United States Serial No. 08/711,982, filed September 10, 1996, U.S. Patent No. 4,806,608, and U.S. Patent No. 4,581,461, each of which are hereby incorporated by reference herein in their entirety.

A wide variety of thermally curable (i.e., thermoset) epoxy-based formulations are suitable for use in the practice of the present invention. Numerous examples of such formulations have been described in the art. See, for example, U.S. Patent No. 5,158,780 and U.S. Patent No. 5,043,102, each of which are hereby incorporated by reference herein in their entirety.

A wide variety of (meth)acrylate-based formulations are suitable for use in the practice of the present invention. Numerous examples of such formulations have been described in the art. See, for example, U.S. Patent No. 5,043,102, hereby incorporated by reference herein in its entirety.

A wide variety of vinyl ether-based formulations are suitable for use in the practice of the present invention. Numerous examples of such formulations have been described in the art. See, for example, United States Serial No. 08/460,495, filed June 2, 1995, which is hereby incorporated by reference herein in its entirety.

A wide variety of vinyl ester-based formulations are suitable for use in the practice of the present invention. Numerous examples of such formulations have been described in the art. See, for example, U.S. Patent No. 5,475,048, which is hereby incorporated by reference herein in its entirety.

A wide variety of allyl ester-based formulations are suitable for use in the practice of the present invention. Numerous examples of such formulations have been described in the art. See, for example, U.S. Patent No. 5,475,048, which is hereby incorporated by reference herein in its entirety.

A wide variety of diallyl amide-based formulations are suitable for use in the practice of the present invention. Numerous examples of such formulations have been described in the art. See, for example, each of which are hereby incorporated by reference herein in their entirety.

A wide variety of propargyl ether-based formulations are suitable for use in the practice of the present invention. Numerous examples of such formulations have been described in the art. See, for example, United States Serial No. 08/684,148, filed July 19, 1996, which is hereby incorporated by reference herein in its entirety.

Presently preferred adhesive formulations contemplated for use in the practice of the present invention comprise a mixture of maleimide and vinyl ether.

Optionally, adhesive formulations contemplated for use in the practice of the present invention further comprise at least one filler. Fillers contemplated for use herein include electrically conductive and thermally conductive materials, as well as non-conductive materials, which impart insulating properties to the resulting formulation.

Examples of electrically conductive fillers contemplated for use herein include silver, nickel, cobalt, copper, aluminum, metal-coated graphite fibers (e.g., employing such metals as nickel, silver, copper, and the like as the metal coating), and the like, as well as mixtures thereof. The presently preferred electrically conductive filler contemplated for use herein is silver. Both powder and flake forms of filler may be used in the attach paste compositions of the present invention. The preferred thickness of flake is under 2 microns with a dimension of about 20 to about 25 microns. Flake contemplated for use herein preferably has a surface area of about 0.15 to 5.0 m²/g and a tap density of 0.4 to 5.5 g/cc. Powder contemplated for use herein preferably has a diameter of about 0.5 to 15 microns.

Thermally conductive fillers contemplated for use in the practice of the present invention include diamond, boron nitride, alumina, aluminum nitride, silicon carbide, magnesium oxide, and the like, as well as mixtures of any two or more thereof.

Catalysts contemplated for use in the practice of the present invention are those which initiate curing of the adhesive formulation at a desirably low temperature, and which also promote curing of adhesive formulations at a sufficiently rapid rate such that the cure peak maximum similarly occurs at a desirably low temperature, e.g., at a temperature of no greater than about 100°C. Presently preferred catalysts contemplated for use herein are those which promote curing of adhesive formulations at a rate such that the cure peak maximum occurs at a temperature of no greater than about 90°C. Especially preferred catalysts contemplated for use herein are those which promote curing of adhesive formulations at a rate such that the cure peak maximum occurs at a temperature of no greater than about 80°C.

Even more preferred for use herein are catalysts which promote curing of adhesive formulations at a rate such that the cure peak maximum occurs at a temperature of no greater than about 70°C, with catalysts which promote curing of adhesive formulations at a rate such that the cure peak maximum occurs at a temperature of no greater than about 60°C being especially preferred with certain adhesive formulations.

Catalysts contemplated for use in the practice of the present invention include free radical catalysts, anionic cure catalysts, cationic cure catalysts, transition metal catalysts, and the like, as well as combinations of any two or more thereof.

Exemplary free radical catalysts contemplated for use in the practice of the present invention include peroxy esters, peroxy carbonates, hydroperoxides, alkylperoxides, arylperoxides, and the like. Specific free radical initiators contemplated for use herein include cumyl peroxyneodecanoate, cumyl peroxyneoheptanoate, tert-amyl peroxyneodecanoate, tert-butyl peroxyneodecanoate, tert-amyl peroxyneoheptanoate, tert-butyl peroxyneoheptanoate, a peroxydicarbonate, 2,4,4-trimethylpentyl-2-peroxyneodecanoate, di(n-propyl) peroxydicarbonate, di-(sec-butyl) peroxydicarbonate, di-(4-tert-butylcyclohexyl) peroxydicarbonate, di-(2-ethylhexyl) peroxydicarbonate, dimyristyl peroxydicarbonate, tert-amyl peroxypivalate, tert-butyl peroxypivalate, di-[3,5,5-trimethylhexanoyl] peroxide, decanoyl peroxide, lauroyl peroxide, dilauroyl peroxide, di-isononanoyl peroxide, 2,5-dimethyl-2,5-di(2-ethylhexanoylperoxy) hexane, 1-amyl peroxy 2-ethylhexanoate, and the like, as well as combinations of any two or more thereof.

Exemplary anionic cure catalysts contemplated for use in the practice of the present invention include imidazoles, tertiary amines, and the like. Imidazoles contemplated for use herein are those having the generic structure: 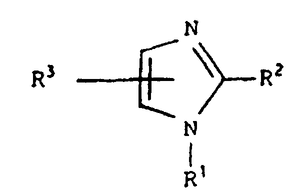 wherein:
R¹ is selected from the group consisting of alkyl, aryl and cyano moieties;
R² is selected from the group consisting of alkyl, aryl and cyano moieties; and
R³ is selected from the group consisting of alkyl, substituted alkyl, alkylaryl and substituted alkylaryl moieties.

As employed herein, "alkyl" refers to straight or branched chain alkyl radicals having in the range of about 1 up to 12 carbon atoms; "substituted alkyl" refers to alkyl radicals further bearing one or more substituents such as hydroxy, alkoxy (of a lower alkyl group), mercapto (of a lower alkyl group), aryl, heterocyclic, halogen, trifluoromethyl, cyano, nitro, amino, carboxyl, carbamate, sulfonyl, sulfonamide, and the like.

As employed herein, "aryl" refers to aromatic radicals having in the range of 6 up to 14 carbon atoms and "substituted aryl" refers to aryl radicals further bearing one or more substituents as set forth above.

As employed herein "alkylaryl" refers to alkylsubstituted aryl radicals and "substituted alkylaryl" refers to alkylaryl radicals further bearing one or more substituents as set forth above.

Exemplary imidazoles contemplated for use herein include 2-ethyl-4-methyl imidazole, 1-methyl imidazole, 2-methyl imidazole, 2-undecyl imidazole, 2-phenyl imidazole, and the like.

Tertiary amines contemplated for use herein include hexadecyl-dimethylamine, dihexadecylmethylamine, octadecyldimethyl-amine, dioctadecylmethylamine, dimethylbehenylamine, dimethyleicosylamine, N,N,N'-trimethyl-N'-hexadecyl-1,2-diaminoethane,N,N,N'-trimethyl-N'-octadecyl-1,2-diamino-ethane, N,N,N'-trimethyl-N'-eicosyl-1,2-diaminoethane,N,N,N'-trimethyl-N'-behenyl-1,2-diaminoethane,- N,N,N',N'-tetramethyl-1,20-diamino-(10,11-dioctyl)-eicosane, and the like, as well as mixtures of any two or more thereof.

Exemplary cationic cure catalysts contemplated for use in the practice of the present invention include onium salts, iodonium salts, sulfonium salts, and the like.

Exemplary transition metal catalysts contemplated for use in the practice of the present invention include nickel, copper, cobalt and the like, in the form of a chelate, a soap, or the like.

Generally in the range of about 0.005 up to 10 wt % of at least one of the above-described catalysts (based on the total weight of the organic phase, i.e., absent any filler) will be employed, with in the range of about 0.01 up to 5 wt % being presently preferred.

As readily recognized by those of skill in the art, a wide variety of devices can be bonded in accordance with the present invention. Examples of such devices include silicon-based microelectronic devices, gallium arsenide-based microelectronic devices, quartz-based microelectronic devices, sapphire-based microelectronic devices, indium phosphide-based microelectronic devices, cadmium sulfide-based microelectronic devices, lithium niobate-based microelectronic devices, and the like.

Those of skill in the art also readily recognize that a variety of substrates can be bonded in accordance with the present invention. Examples of such substrates are boards made of materials which tend to release volatiles upon exposure to elevated temperatures, e.g., boards made of materials which tend to absorb water. Examples of such boards include bismaleimide-triazine boards, epoxy boards, boards having a polyimide film thereon, boards having a polycarbonate film thereon, boards having a solder mask coating thereon, and the like.

In accordance with another embodiment of the present invention, there are provided adhesive compositions useful for attaching a device to a substrate, wherein said device and/or said substrate are prone to release volatiles at elevated temperatures, and wherein there is substantially no void formation upon curing thereof. Invention compositions comprise:
vehicle, and
a catalyst which initiates curing of said vehicle at a temperature of no greater than 100°C.

Vehicles contemplated for use in the practice of the present invention include cyanate ester-based formulations, maleimide-based formulations, epoxy-based formulations, (meth)acrylate-based formulations, vinyl ether-based formulations, vinyl ester-based formulations, allyl ester-based formulations, diallyl amide-based formulations, propargyl ether-based formulations, formulations based on a polysiloxane backbone terminated with one or more of the above-described functional groups, formulations based on a preimidized polyimide backbone terminated with one or more of the above-described functional groups, and the like, as well as mixtures of any two or more thereof, as described hereinabove.

Similarly, catalysts contemplated for use in the preparation of invention compositions are as described above, and such catalysts can be added to invention composition in amounts as set forth above.

As used herein, "substantially void-free" refers to a substantially continuous bond of adhesive between the interconnected device and substrate. Voids manifest as a disruption of this otherwise continuous bond and compromise both the strength of the resulting bond, and the ability of such bond to resist the influence of outside forces, such as high moisture levels, high shear forces, and the like.

The invention will now be described in greater detail by reference to the following non-limiting examples.

### Example 1

A resin system was prepared for testing, using a base formulation as follows, and various different catalysts, to determine the effect of catalyst choice on the occurrence of voids upon curing. The base resin composition employed comprises:
60 parts by wt of the bismaleimide, 1,20-bismaleimido-10,11-dioctyl-eicosane,
30 parts by wt of maleated polybutadiene R130 MA20 from Ricon Resins, Grand Junction, CO),
22 parts by wt of a branched, C₂₄ monovinyl ether (i.e., the monovinyl ether of 2-decyl tetradecanol),
4 parts by wt of a coupling agent (e.g., 3 parts of A-186 (i.e., β-(3,4-epoxycyclohexyl) ethyl trimethoxysilane) and one part of A-174 (i.e., γ-methacryloxypropyl trimethoxysilane), both of which are available from OSi Specialities, Endicott, NY), and
1, 3 or 5 parts by wt of a catalyst.

Catalysts employed herein include Perkadox 16S (di-(4-tert-butylcyclohexyl)peroxydicarbonate, available from Akzo Nobel), Trigonox 141 (2,5-dimethyl-2,5-di-(2-ethylhexanoylperoxy)hexane, available from Akzo Nobel), and Witco USP90MD (1,1-bis(tert-amylperoxy)cyclohexane, available from Witco Chemical). Each of these catalysts has a 10 hour decomposition half life of 70°C or less, and were added to the base formulation described above at levels of 1, 3 or 5 parts by wt. Thus, nine pastes were made for testing, each filled with 77 wt % silver flake. A differential scanning calorimetr (DSC) and a void test was performed on each paste.

The void test was performed using a copper-clad BT (bismaleimide-triazine) resin with Taiyo PSR 4000 version AUS5 solder mask. The substrate was placed in an 85/85 chamber for 15-16 hours to insure that moisture absorption would be evident. The nine plates were attached to the substrate using a glass cover slide 300x300 mils. The pastes were cured at 150°C for 60 seconds on a hot plate apparatus.

The DSC was performed at a ramp rate of 10°C/min. The sample size used was about 20-30 mg. Analysis of the DSC shows the onset of cure, the cure peak maximum and the total energy evolved. The cure onset temperature and the cure peak maximum temperature are presented in the Table for each of the pastes.

**Table**

| Paste* | Cure onset, °C | Cure peak, °C | % Voids |
|---|---|---|---|
| A | 84.20 | 90.46 | 0 |
| B | 77.38 | 82.28 | 0 |
| C | 74.04 | 78.90 | 0 |
| D | 102.62 | 113.15 | 100 |
| E | 95.08 | 103.74 | 100 |
| F | 90.13 | 99.16 | 0 |
| G | 117.79 | 129.08 | 100 |
| H | 111.66 | 122.43 | 100 |
| I | 109.32 | 118.97 | 100 |

| | | | |
|---|---|---|---|
| * Pastes A, B and C contain 1, 3 and 5 parts by wt, respectively, of Perkadox 16S; Pastes D, E and F contain 1, 3 and 5 parts by wt, respectively, of Trigonox 141; and Pastes G, H and I contain 1, 3 and 5 parts by wt, respectively, of Witco USP90MD. | | | |

The results presented above demonstrate that voiding under the die does not occur with moisture sensitive polymers so long as the cure onset and cure peak maximum temperatures are both below 100°C.

While the invention has been described in detail with reference to certain preferred embodiments thereof, it will be understood that modifications and variations are within the spirit and scope of that which is described and claimed.

## Claims

1. A method to reduce void formation upon curing of an adhesive formulation employed to bond a microelectronic device to a substrate, wherein said device and/or said substrate are prone to release volatiles at elevated temperatures, said method comprising using as a curing catalyst for said formulation a catalyst which initiates curing of said formulation at a temperature of less than 100°C.

2. A method according to claim 1 wherein said catalyst promotes curing of said formulation at a rate such that the cure peak maximum occurs at a temperature of no greater than about 100°C.

3. A method according to claim 1 wherein said catalyst is a free radical catalyst, an anionic cure catalyst, a cationic cure catalyst, a transition metal catalyst, or a combination of any two or more thereof.

4. A method according to claim 3 wherein said free radical catalyst is selected from the group consisting of cumyl peroxyneodecanoate, cumyl peroxyneoheptanoate, tert-amyl peroxyneodecanoate, tert-butyl peroxyneodecanoate, tert-amyl peroxyneoheptanoate, tert-butyl peroxyneoheptanoate, a peroxydicarbonate, 2,4,4-trimethylpentyl-2-peroxyneodecanoate, di(n-propyl) peroxydicarbonate, di-(sec-butyl) peroxydicarbonate, di- (4-tert-butylcyclohexyl) peroxydicarbonate, di-(2-ethylhexyl) peroxydicarbonate, dimyristyl peroxydicarbonate, tert-amyl peroxypivalate, tert-butyl peroxypivalate, di-[3,5,5-trimethylhexanoyl] peroxide, decanoyl peroxide, lauroyl peroxide, dilauroyl peroxide, di-isononanoyl peroxide, 2,5-dimethyl-2,5-di(2-ethylhexanoylperoxy) hexane and 1-amyl peroxy 2-ethylhexanoate.

5. A method according to claim 1 wherein said catalyst promotes curing of said formulation at a rate such that the cure peak maximum occurs at a temperature of no greater than about 90°C.

6. A method according to claim 1 wherein said catalyst promotes curing of said formulation at a rate such that the cure peak maximum occurs at a temperature of no greater than about 80°C.

7. A method according to claim 1 wherein said catalyst promotes curing of said formulation at a rate such that the cure peak maximum occurs at a temperature of no greater than about 70°C.

8. A method according to claim 1 wherein said catalyst promotes curing of said formulation at a rate such that the cure peak maximum occurs at a temperature of no greater than about 60°C.

9. A method according to claim 1 wherein said adhesive formulation is a cyanate ester-based formulation, a maleimide-based formulation, an epoxy-based formulation, a (meth)acrylate-based formulation, a vinyl ether-based formulation, a vinyl ester-based formulation, an allyl ester-based formulation, a diallyl amide-based formulation a propargyl ether-based formulation, formulations based on a polysiloxane backbone terminated with one or more of the above-described functional groups, formulations based on a preimidized polyimide backbone terminated with one or more of the above-described functional groups, or mixture of any two or more thereof.

10. A method according to claim 9 wherein said adhesive formulation comprises a mixture of maleimide and vinyl ether.

11. A method according to claim 9 wherein said adhesive formulation further comprises at least one filler.

12. A method according to claim 1 wherein said device is a silicon-based microelectronic device, a gallium arsenide-based microelectronic device, a quartz-based microelectronic device, a sapphire-based microelectronic device, an indium phosphide-based microelectronic device, a cadmium sulfide-based microelectronic device, or a lithium niobate-based microelectronic device.

13. A method according to claim 1 wherein said substrate is a board which releases volatiles upon exposure to elevated temperatures.

14. A method according to claim 13 wherein said substrate is a bismaleimide-triazine board, an epoxy board, a board having a polyimide film thereon, a board having a polycarbonate film thereon, or a board having a solder mask coating thereon.

15. An adhesive composition useful for attaching a microelectronic device to a substrate, wherein said device and/or said substrate are prone to release volatiles at elevated temperatures, and wherein there is substantially no void formation upon curing thereof, said composition comprising:
vehicle, and
a catalyst which initiates curing of said vehicle at a temperature of no greater than 100°C.

16. A composition according to claim 15 wherein said catalyst promotes curing of said composition at a rate such that the cure peak maximum occurs at a temperature of no greater than about 100°C.

17. A composition according to claim 15 wherein said catalyst is a free radical catalyst, an anionic cure catalyst, a cationic cure catalyst, a transition metal catalyst, or a combination of any two or more thereof.

18. A composition according to claim 17 wherein said free radical catalyst is selected from the group consisting of cumyl peroxyneodecanoate, cumyl peroxyneoheptanoate, tert-amyl peroxyneodecanoate, tert- butyl peroxyneodecanoate, tert-amyl peroxyneoheptanoate, tert-butyl peroxyneoheptanoate, a peroxydicarbonate, 2,4,4-trimethylpentyl-2-peroxyneodecanoate, di(n-propyl) peroxydicarbonate, di-(sec-butyl) peroxydicarbonate, di-(4-tert-butylcyclohexyl) peroxydicarbonate, di-(2-ethylhexyl) peroxydicarbonate, dimyristyl peroxydicarbonate, tert-amyl peroxypivalate, tert-butyl peroxypivalate, di-[3,5,5-trimethylhexanoyl] peroxide, decanoyl peroxide, lauroyl peroxide, dilauroyl peroxide, di-isononanoyl peroxide, 2,5-dimethyl-2,5-di(2-ethylhexanoylperoxy)hexane and 1-amyl peroxy 2-ethylhexanoate.

19. A composition according to claim 15 wherein said catalyst promotes curing of said formulation at a rate such that the cure peak maximum occurs at a temperature of no greater than about 90°C.

20. A composition according to claim 15 wherein said catalyst promotes curing of said formulation at a rate such that the cure peak maximum occurs at a temperature of no greater than about 80°C.

21. A composition according to claim 15 wherein said catalyst promotes curing of said formulation at a rate such that the cure peak maximum occurs at a temperature of no greater than about 70°C.

22. A composition according to claim 15 wherein said catalyst promotes curing of said formulation at a rate such that the cure peak maximum occurs at a temperature of no greater than about 60°C.

23. A composition according to claim 15 wherein said vehicle is a cyanate ester-based formulation, a maleimide-based formulation, an epoxy-based formulation, a (meth)acrylate-based formulation, a vinyl ether-based formulation, a vinyl ester-based formulation, an allyl ester-based formulation, a diallyl amide-based formulation a propargyl ether-based formulation, formulations based on a polysiloxane backbone terminated with one or more of the above-described functional groups, formulations based on a preimidized polyimide backbone terminated with one or more of the above-described functional groups, or a mixture of any two or more thereof.

24. A composition according to claim 15 wherein said vehicle comprises a mixture of maleimide and vinyl ether.

25. A composition according to claim 15 wherein said composition further comprises at least one filler.

26. A substantially void-free article prepared according to the method of claim 1.

## Patentansprüche

1. Verfahren zur Verminderung von Hohlraumbildung beim Härten einer Klebstoff-Zubereitung, die zum Verbinden einer mikroelektronischen Vorrichtung mit einem Substrat verwendet wird, wobei die Vorrichtung und/oder das Substrat dazu neigen, bei erhöhten Temperaturen flüchtige Stoffe freizusetzen, wobei das Verfahren als Härtekatalysator für die Zubereitung die Verwendung eines Katalysators umfasst, der das Härten der Zubereitung bei einer Temperatur von weniger als 100 °C initiiert.

2. Verfahren gemäß Anspruch 1, wobei der Katalysator das Härten der Zubereitung mit einer Geschwindigkeit fördert, so dass das Aushärtungsspitzenmaximum bei einer Temperatur von nicht mehr als etwa 100 °C auftritt.

3. Verfahren gemäß Anspruch 1, wobei der Katalysator ein radikalischer Katalysator, ein anionischer Härtekatalysator, ein kationischer Härtekatalysator, ein Übergangsmetall-Katalysator oder eine Kombination von zwei oder mehreren davon ist.

4. Verfahren gemäß Anspruch 3, wobei der radikalische Katalysator ausgewählt wird aus der Gruppe bestehend aus Cumolperoxyneodecanoat, Cumolperoxyneoheptanoat, tert-Amylperoxyneodecanoat, tert-Butylperoxyneodecanoat, tert-Amylperoxyneoheptanoat, tert-Butylperoxyneoheptanoat, einem Peroxydicarbonat, 2,4,4-Trimethylpentyl-2-peroxyneodecanoat, Di-(n-propyl)-peroxydicarbonat, Di-(sek-butyl)-peroxydicarbonat, Di-(4-tert-butylcyclohexyl)-peroxydicarbonat, Di-(2-ethylhexyl)-peroxydicarbonat, Dimyristylperoxydicarbonat, tert-Amylperoxypivalat, tert-Butylperoxypivalat, Di-[3,5,5-trimethylhexanoyl]-peroxid, Decanoylperoxid, Lauroylperoxid, Dilauroylperoxid, Diisononanoylperoxid, 2,5-Dimethyl-2,5-di(2-ethylhexanoylperoxy)-hexan und 1-Amylperoxy-2-ethylhexanoat.

5. Verfahren gemäß Anspruch 1, wobei der Katalysator das Härten der Zubereitung mit einer Geschwindigkeit fördert, so dass das Aushärtungsspitzenmaximum bei einer Temperatur von nicht mehr als etwa 90 °C auftritt.

6. Verfahren gemäß Anspruch 1, wobei der Katalysator das Härten der Zubereitung mit einer Geschwindigkeit fördert, so dass das Aushärtungsspitzenmaximum bei einer Temperatur von nicht mehr als etwa 80 °C auftritt.

7. Verfahren gemäß Anspruch 1, wobei der Katalysator das Härten der Zubereitung mit einer Geschwindigkeit fördert, so dass das Aushärtungsspitzenmaximum bei einer Temperatur von nicht mehr als etwa 70 °C auftritt.

8. Verfahren gemäß Anspruch 1, wobei der Katalysator das Härten der Zubereitung mit einer Geschwindigkeit fördert, so dass das Aushärtungsspitzenmaximum bei einer Temperatur von nicht mehr als etwa 60 °C auftritt.

9. Verfahren gemäß Anspruch 1, wobei die Klebstoff-Zubereitung eine Cyanatester-basierende Zubereitung, eine Maleinimid-basierende Zubereitung, eine Epoxy-basierende Zubereitung, eine (Meth-)Acrylat-basierende Zubereitung, eine Vinylether-basierende Zubereitung, eine Vinylester-basierende Zubereitung, eine Allylester-basierende Zubereitung, eine Diallylamid-basierende Zubereitung, eine Propargylether-basierende Zubereitung, Zubereitungen auf Basis einer Polysiloxan-Hauptkette mit einer oder mehreren der vorstehend beschriebenen funktionalen Gruppen am Ende, Zubereitungen auf Basis einer vorimidisierten Polyimid-Hauptkette mit einer oder mehreren der vorstehend beschriebenen funktionalen Gruppen am Ende, oder eine Mischung aus zwei oder mehreren davon ist.

10. Verfahren gemäß Anspruch 9, wobei die Klebstoff-Zubereitung eine Mischung aus Maleinimid und Vinylether enthält.

11. Verfahren gemäß Anspruch 9, wobei die Klebstoff-Zubereitung weiterhin wenigstens ein Streckmittel enthält.

12. Verfahren gemäß Anspruch 1, wobei die Vorrichtung eine mikroelektronische Vorrichtung auf Siliciumbasis, eine mikroelektronische Vorrichtung auf Galliumarsenidbasis, eine mikroelektronische Vorrichtung auf Quarzbasis, eine mikroelektronische Vorrichtung auf Saphirbasis, eine mikroelektronische Vorrichtung auf Indiumphosphidbasis, eine mikroelektronische Vorrichtung auf Cadmiumsulfidbasis oder eine mikroelektronische Vorrichtung auf Lithiumniobatbasis ist.

13. Verfahren gemäß Anspruch 1, wobei das Substrat eine Platine ist, die flüchtige Stoffe beim Aussetzen an erhöhte Temperaturen freisetzt.

14. Verfahren gemäß Anspruch 13, wobei das Substrat eine Bismaleinimidtriazin-Platine, eine Epoxyplatine, eine Platine mit einem Polyimidfilm darauf, eine Platine mit einem Polycarbonatfilm darauf oder eine Platine mit einer Lötmaskenbeschichtung darauf ist.

15. Klebstoff-Zusammensetzung, geeignet zum Befestigen einer mikroelektronischen Vorrichtung an einem Substrat, wobei die Vorrichtung und/oder das Substrat dazu neigen, bei erhöhten Temperaturen flüchtige Stoffe freizusetzen, und wobei im Wesentlichen keine Hohlraumbildung bei der Härtung der Zusammensetzung auftritt, die enthält:
ein Bindemittel, und
einen Katalysator, der das Härten des Bindemittels bei einer Temperatur von nicht mehr als 100 °C initiiert.

16. Zusammensetzung gemäß Anspruch 15, wobei der Katalysator das Härten der Zusammensetzung mit einer Geschwindigkeit fördert, so dass das Aushärtungsspitzenmaximum bei einer Temperatur von nicht mehr als etwa 100 °C auftritt.

17. Zusammensetzung gemäß Anspruch 15, wobei der Katalysator ein radikalischer Katalysator, ein anionischer Härtekatalysator, ein kationischer Härtekatalysator, ein Übergangsmetall-Katalysator, oder eine Kombination von zwei oder mehreren davon ist.

18. Zusammensetzung gemäß Anspruch 17, wobei der radikalische Katalysator ausgewählt wird aus der Gruppe bestehend aus Cumolperoxyneodecanoat, Cumolperoxyneoheptanoat, tert-Amylperoxyneodecanoat, tert-Butylperoxyneodecanoat, tert-Amylperoxyneoheptanoat, tert-Butylperoxyneoheptanoat, einem Peroxydicarbonat, 2,4,4-Trimethylpentyl-2-peroxyneodecanoat, Di-(n-propyl)-peroxydicarbonat, Di-(sek-butyl)-peroxydicarbonat, Di-(4-tert-butylcyclohexyl)-peroxydicarbonat, Di-(2-ethylhexyl)-peroxydicarbonat, Dimyristylperoxydicarbonat, tert-Amylperoxypivalat, tert-Butylperoxypivalat, Di-[3,5,5-trimethylhexanoyl]-peroxid, Decanoylperoxid, Lauroylperoxid, Dilauroylperoxid, Diisononanoylperoxid, 2,5-Dimethyl-2,5-di(2-ethylhexanoylperoxy)-hexan und 1-Amylperoxy-2-ethylhexanoat.

19. Zusammensetzung gemäß Anspruch 15, wobei der Katalysator das Härten der Zusammensetzung mit einer Geschwindigkeit fördert, so dass das Aushärtungsspitzenmaximum bei einer Temperatur von nicht mehr als etwa 90 °C auftritt.

20. Zusammensetzung gemäß Anspruch 15, wobei der Katalysator das Härten der Zusammensetzung mit einer Geschwindigkeit fördert, so dass das Aushärtungsspitzenmaximum bei einer Temperatur von nicht mehr als etwa 80 °C auftritt.

21. Zusammensetzung gemäß Anspruch 15, wobei der Katalysator das Härten der Zusammensetzung mit einer Geschwindigkeit fördert, so dass das Aushärtungsspitzenmaximum bei einer Temperatur von nicht mehr als etwa 70 °C auftritt.

22. Zusammensetzung gemäß Anspruch 15, wobei der Katalysator das Härten der Zusammensetzung mit einer Geschwindigkeit fördert, so dass das Aushärtungsspitzenmaximum bei einer Temperatur von nicht mehr als etwa 60 °C auftritt.

23. Zusammensetzung gemäß Anspruch 15, wobei das Bindemittel eine Cyanatester-basierende Zubereitung, eine Maleinimid-basierende Zubereitung, eine Epoxy-basierende Zubereitung, eine (Meth-)Acrylat-basierende Zubereitung, eine Vinylether-basierende Zubereitung, eine Vinylester-basierende Zubereitung, eine Allylester-basierende Zubereitung, eine Diallylamid-basierende Zubereitung, eine Propargylether-basierende Zubereitung, Zubereitungen auf Basis einer Polysiloxan-Hauptkette mit einer oder mehreren der vorstehend beschriebenen funktionalen Gruppen am Ende, Zubereitungen auf Basis einer vorimidisierten Polyimid-Hauptkette mit einer oder mehreren der vorstehend beschriebenen funktionalen Gruppen am Ende, oder eine Mischung aus zwei oder mehreren davon ist.

24. Zusammensetzung gemäß Anspruch 15, wobei das Bindemittel eine Mischung aus Maleinimid und Vinylether enthält.

25. Zusammensetzung gemäß Anspruch 15, wobei die Zusammensetzung weiterhin wenigstens ein Streckmittel enthält.

26. Bauteil, das im Wesentlichen hohlraumfrei und nach dem Verfahren gemäß Anspruch 1 hergestellt ist.

## Revendications

1. Procédé pour réduire la formation de vides lors du durcissement d'une composition adhésive employée pour lier un dispositif micro-électronique à un substrat, dans lequel ledit dispositif et/ou ledit substrat sont susceptibles de libérer des matières volatiles à température élevée, ledit procédé comprenant l'utilisation, comme catalyseur de durcissement pour ladite composition, d'un catalyseur qui initie le durcissement de ladite composition à une température inférieure à 100° C.

2. Procédé selon la revendication 1, dans lequel ledit catalyseur active le durcissement de ladite composition à une vitesse telle que le maximum du pic de durcissement ait lieu à une température ne dépassant pas environ 100° C.

3. Procédé selon la revendication 1, dans lequel ledit catalyseur est un catalyseur radicalaire, un catalyseur de durcissement anionique, un catalyseur de durcissement cationique, un catalyseur à base de métal de transition, ou une combinaison de deux quelconques ou plus de ceux-ci.

4. Procédé selon la revendication 3, dans lequel ledit catalyseur radicalaire est choisi dans le groupe constitué par le peroxynéodécanoate de cumyle, le peroxynéoheptanoate de cumyle, le peroxynéodécanoate de tert-amyle, le peroxynéodécanoate de tert-butyle, le peroxynéoheptanoate de tert-amyle, le peroxynéoheptanoate de tert-butyle, un peroxydicarbonate, le 2-peroxynéodécanoate de 2,4,4-triméthylpentyle, le peroxydicarbonate de di(n-propyle), le peroxydicarbonate de di(sec-butyle), le peroxydicarbonate de di(4-tert-butylcyclohexyle), le peroxydicarbonate de di(2-éthylhexyle), le peroxydicarbonate de dimyristyle, le peroxypivalate de tert-amyle, le peroxypivalate de tert-butyle, le peroxyde de di[3,5,5-triméthyl-hexanoyle], le peroxyde de décanoyle, le peroxyde de lauroyle, le peroxyde de dilauroyle, le peroxyde de diisononanoyle, le 2,5-diméthyl-2,5-di(2-éthylhexanoylperoxy) hexane et le peroxy-2-éthylhexanoate de 1-amyle.

5. Procédé selon la revendication 1, dans lequel ledit catalyseur active le durcissement de ladite composition à une vitesse telle que le maximum du pic de durcissement ait lieu à une température ne dépassant pas environ 90° C.

6. Procédé selon la revendication 1, dans lequel ledit catalyseur active le durcissement de ladite composition à une vitesse telle que le maximum du pic de durcissement ait lieu à une température ne dépassant pas environ 80° C.

7. Procédé selon la revendication 1, dans lequel ledit catalyseur active le durcissement de ladite composition à une vitesse telle que le maximum du pic de durcissement ait lieu à une température ne dépassant pas environ 70° C.

8. Procédé selon la revendication 1, dans lequel ledit catalyseur active le durcissement de ladite composition à une vitesse telle que le maximum du pic de durcissement ait lieu à une température ne dépassant pas environ 60° C.

9. Procédé selon la revendication 1, dans lequel ladite composition adhésive est une composition à base d'ester cyanate, une composition à base de maléimide, une composition à base de composé époxy, une composition à base de (méth)acrylate, une composition à base d'éther vinylique, une composition à base d'ester vinylique, une composition à base d'ester allylique, une composition à base de diallylamide, une composition à base d'éther propargylique, des compositions à base d'un squelette polysiloxane terminé par un ou plusieurs des groupes fonctionnels décrits ci-dessus, des compositions à base d'un squelette polyimide préimidisée terminé par un ou plusieurs des groupes fonctionnels décrits ci-dessus, ou un mélange de deux quelconques ou plus de celles-ci.

10. Procédé selon la revendication 9, dans lequel ladite composition adhésive comprend un mélange de maléimide et d'éther vinylique.

11. Procédé selon la revendication 9, dans lequel ladite composition adhésive comprend en outre au moins une charge.

12. Procédé selon la revendication 1, dans lequel ledit dispositif est un dispositif micro-électronique à base de silicium, un dispositif micro-électronique à base d'arséniure de gallium, un dispositif micro-électronique à base de quartz, un dispositif micro-électronique à base de saphir, un dispositif micro-électronique à base de phosphure d'indium, un dispositif micro-électronique à base de sulfure de cadmium, ou un dispositif micro-électronique à base de niobate de lithium.

13. Procédé selon la revendication 1, dans lequel ledit substrat est une plaquette qui libère des matières volatiles lorsqu'elle est exposée à des températures élevées.

14. Procédé selon la revendication 13, dans lequel ledit substrat est une plaquette à base de bis-maléimide-triazine, une plaquette à base de composé époxy, une plaquette portant un film de polyimide, une plaquette portant un film de polycarbonate, ou une plaquette portant un revêtement de masque de soudure.

15. Composition adhésive utile pour attacher un dispositif micro-électronique à un substrat, pour laquelle ledit dispositif et/ou ledit substrat sont susceptibles de libérer des matières volatiles à température élevée et pour laquelle il n'y a pratiquement pas de formation de vides lors de son durcissement, ladite composition comprenant : un véhicule et un catalyseur qui initie le durcissement dudit véhicule à une température ne dépassant pas 100° C.

16. Composition selon la revendication 15, dans laquelle ledit catalyseur active le durcissement de ladite composition à une vitesse telle que le maximum du pic de durcissement ait lieu à une température ne dépassant pas environ 100° C.

17. Composition selon la revendication 15, dans laquelle ledit catalyseur est un catalyseur radicalaire, un catalyseur de durcissement anionique, un catalyseur de durcissement cationique, un catalyseur à base de métal de transition, ou une combinaison de deux quelconques ou plus de ceux-ci.

18. Composition selon la revendication 17, dans laquelle ledit catalyseur radicalaire est choisi dans le groupe constitué par le peroxynéodécanoate de cumyle, le peroxynéoheptanoate de cumyle, le peroxynéodécanoate de tert-amyle, le peroxynéodécanoate de tert-butyle, le peroxynéoheptanoate de tert-amyle, le peroxynéoheptanoate de tert-butyle, un peroxydicarbonate, le 2-peroxynéodécanoate de 2,4,4-triméthylpentyle, le peroxydicarbonate de di(n-propyle), le peroxydicarbonate de di(sec-butyle), le peroxydicarbonate de di(4-tert-butylcyclohexyle), le peroxydicarbonate de di(2-éthylhexyle), le peroxydicarbonate de di-dimyristyle, le peroxypivalate de tert-amyle, le peroxypivalate de tert-butyle, le peroxyde de di[3,5,5-triméthyl-hexanoyle], le peroxyde de décanoyle, le peroxyde de lauroyle, le peroxyde de dilauroyle, le peroxyde de diisononanoyle, le 2,5-diméthyl-di(2-éthylhexanoylperoxy) hexane et le peroxy-2-éthylhexanoate de 1-amyle.

19. Composition selon la revendication 15, dans laquelle ledit catalyseur active le durcissement de ladite composition à une vitesse telle que le maximum du pic de durcissement ait lieu à une température ne dépassant pas environ 90° C.

20. Composition selon la revendication 15, dans laquelle ledit catalyseur active le durcissement de ladite composition à une vitesse telle que le maximum du pic de durcissement ait lieu à une température ne dépassant pas environ 80° C.

21. Composition selon la revendication 15, dans laquelle ledit catalyseur active le durcissement de ladite composition à une vitesse telle que le maximum du pic de durcissement ait lieu à une température ne dépassant pas environ 70° C.

22. Composition selon la revendication 15, dans laquelle ledit catalyseur active le durcissement de ladite composition à une vitesse telle que le maximum du pic de durcissement ait lieu à une température ne dépassant pas environ 60° C.

23. Composition selon la revendication 15, dans laquelle ledit véhicule est une composition à base d'ester cyanate, une composition à base de maléimide, une composition à base de composé époxy, une composition à base de (méth)acrylate, une composition à base d'éther vinylique, une composition à base d'ester vinylique, une composition à base d'ester allylique, une composition à base de diallylamide, une composition à base d'éther propargylique, des compositions à base d'un squelette polysiloxane terminé par un ou plusieurs des groupes fonctionnels décrits ci-dessus, des compositions à base d'un squelette polyimide préimidisée terminé par un ou plusieurs des groupes fonctionnels décrits ci-dessus, ou un mélange de deux quelconques ou plus de celles-ci.

24. Composition selon la revendication 15, dans laquelle ledit véhicule comprend un mélange de maléimide et d'éther vinylique.

25. Composition selon la revendication 15, dans laquelle ladite composition comprend en outre au moins une charge.

26. Article pratiquement dépourvu de vides préparé selon le procédé de la revendication 1.
